# EUROPEAN PATENT APPLICATION

(11) **EP 2 413 250 A1**
(43) Date of publication of application: **01.02.2012**
(21) Application number: 09842107.6
(22) Date of filing: 23.12.2009
(51) Int. Cl.: G06F 17/22

(54) **METHOD AND SYSTEM FOR COMPRESSED ENCODING AND DECODING FOR WORD STOCK**

(30) Priority: 27.03.2009 CN 200910038254
(71) Applicant: Guangdong Guobi Technology Co., Ltd., Guangdong 510620 (CN)
(72) Inventor: GAO, Jinglian, Guangdong 510620 (CN)
(74) Representative: Tergau & Walkenhorst
(86) International application number: PCT/CN2009/075898
(87) International publication number: WO 2010/108373

(57) **Abstract**

A method for compression encoding for a word stock comprises the following steps of: A. generating a first frequency table by statistically analyzing each word in the word stock, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock; B. arranging all occurrence numbers in each letter frequency data list of the first frequency table according to number values, and summing up all occurrence numbers that each corresponds to a same arrangement order in all letter frequency data lists, to generate a sum-frequency data list to form a second frequency table; C. encoding all numbers in the sum-frequency data list by performing Huffman encoding, to generate a binary code list to form an encode table, wherein a binary code in the binary code list corresponds to a number in the sum-frequency data list with a same arrangement order; and D. encoding all letters of a word in the word stock into an encoded binary code, according to arrangement orders of all letters of the word in the encode table. The present invention further provides a system for compression encoding for a word stock, and a method and a system for decoding an encoded word stock.

## Description

### TECHNICAL FIELD

The present invention relates to technologies of compression encoding, and more particularly, to a method and a system for compression encoding and decoding for a word stock.

### DESCRIPTION OF RELATED ART

Conventionally, Huffman encoding is adopted for compression encoding for a word stock. In the Huffman encoding, a Huffman tree is constructed according to the arrangement orders of occurrence numbers of letters in a word, and letters acting more frequently are assigned binary codes with a shorter length so that an average code length of all words in the word stock is made as short as possible. However, the compression ratio of performing the Huffman encoding on words in this way is not high enough. As statistic data shows, the compression ratio of the Huffman encoding is 48.84% for English word stocks, 48.64% for Russian word stocks, 51.68% for Turkish word stocks, 56.50% for Arabic word stocks, and 46.45% for Portuguese word stocks. Obviously, there is still great room for improvement in the compression ratio for word stocks of various languages. However, use of other Lzw compression algorithms will make the computational burden much heavy. Therefore, an urgent need exists for a word stock compression method that allows for simple decoding and has a higher compression ratio.

The Huffman encoding has a characteristic that, the greater the frequency differences between individual codes are, namely, the larger the coincident code rate is, the higher the compression ratio will be. Using this characteristic, increasing the coincident code rate is very critical for improvement of the compression ratio of the Huffman encoding.

### BRIEF SUMMARY OF THE INVENTION

In view of the shortcomings in the prior art, a first problem that needs to be solved by the present invention is to provide a method for compression encoding for a word stock, which can increase the coincident code rate of encoding of words in the word stock so as to improve the compression ratio of performing the Huffman encoding on the words in the word stock.

A second problem that needs to be solved by the present invention is to provide a system for compression encoding for a word stock, which can increase the coincident code rate of encoding of words in the word stock so as to improve the compression ratio of performing the Huffman encoding on the words in the word stock.

A third problem that needs to be solved by the present invention is to provide a method for decoding an encoded word stock, which can decode encoded words in a fast and simple way.

A fourth problem that needs to be solved by the present invention is to provide a system for decoding an encoded word stock, which can decode encoded words in a fast and simple way.

To solve the first problem, the present invention provides the following technical solutions: a method for compression encoding for a word stock is provided, which comprises the following steps of:
A. generating a first frequency table by statistically analyzing each word in the word stock, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock;
B. arranging all occurrence numbers in each letter frequency data list of the first frequency table according to number values, and summing up all occurrence numbers that each corresponds to a same arrangement order in all letter frequency data lists, to generate a sum-frequency data list to form a second frequency table;
C. encoding all numbers in the sum-frequency data list by performing Huffman encoding, to generate a binary code list to form an encode table, wherein a binary code in the binary code list corresponds to a number in the sum-frequency data list with a same arrangement order; and
D. encoding all letters of a word in the word stock into an encoded binary code according to arrangement orders of all letters of the word in the encode table.

As an embodiment of the method for compression encoding for a word stock according to the present invention, the step A further comprises the following steps of:
A1. obtaining a word to read an initial letter thereof;
A2. determining whether a letter that is currently read is an initial letter; if the answer is "yes', then the frequency of the letter acting as an initial letter is increased by one, and if the answer is "no", the frequency of the letter acting as a letter subsequent to a previous letter is increased by one;
A3. taking the letter that is currently read as a current previous letter;
A4. determining whether the letter that is currently read is the last letter of the word; if the answer is "no", then a next letter is read and the process returns to the step A2, and if the answer is "yes", then the process returns to the step A1, and this cycle proceeds until statistics have been made on all the words in the word stock; and
A5. generating the first frequency table, wherein the first frequency table comprises a plurality of data lists, each data list corresponding to occurrence numbers of one letter's subsequent letters, and also comprises a data list corresponding to occurrence numbers of each letter as an initial letter.

As an embodiment of the method for compression encoding for a word stock according to the present invention, the initial letter frequency data list and the plurality of subsequent letter frequency data lists in the first frequency table are used as row data in the frequency table, and the same arrangement orders described in the step B are at locations in a same column order of the second frequency table.

As an embodiment of the method for compression encoding for a word stock according to the present invention, the step C further comprises:
C1. constructing a Huffman tree by using the plurality of sum frequencies as a plurality of nodes;
C2. identifying a left child path of each of the nodes in the Huffman tree as 0 and a right child path of each of the nodes as 1, and then obtaining a path from each of the nodes corresponding to the sum frequencies to a root node to obtain binary codes corresponding to the respective sum frequencies; and
C3. assigning the binary codes to columns in which the corresponding sum frequencies are located in the second frequency table, and replacing the frequency data in the second frequency table with corresponding subsequent letters to generate an encode table.

As an embodiment of the method for compression encoding for a word stock according to the present invention, the step D comprises:
D1. obtaining a word;
D2. finding a column in which the initial letter of the word is located from a row corresponding to the initial letter in the encode table, and replacing the initial letter with a binary code corresponding to the column;
D3. reading a next letter and a previous letter thereof; and
D4. finding a row in which the previous letter is located from the encode table, finding a column in which the letter that is currently read is located from the row, replacing the letter that is currently read with a binary code corresponding to the column, and returning to the step D3 to repeat the process until the last letter of the word has been replaced, thereby generating a binary code corresponding to the word, and then returning to the step D1.

To solve the second problem, the present invention provides the following technical solutions: a system for compression encoding for a word stock is provided, which comprises: a word stock configured to store words; a statistics module configured to generate a first frequency table by statistically analyzing each word in the word stock, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock; a storage module configured to store the first frequency table and the encode table generated by a Huffman encoding module; a second frequency table generating module configured to arrange all occurrence numbers in each letter frequency data list of the first frequency table according to number values, and summing up all occurrence numbers that each corresponds to a same arrangement order in all letter frequency data lists, to generate a sum-frequency data list to form a second frequency table; a Huffman encoding module configured to encode all numbers in the sum-frequency data list by performing Huffman encoding, to generate a binary code list to form an encode table, wherein a binary code in the binary code list corresponds to a number in the sum-frequency data list with a same arrangement order; and a code replacing module configured to encode all letters of a word in the word stock into an encoded binary code according to arrangement orders of all letters of the word in the encode table.

To solve the third problem, the present invention provides the following technical solutions: the present invention further provides a method for decoding an encoded word stock, which comprises the following steps of:
E. obtaining a binary code of a word;
F. disassembling the binary code obtained in the step E into a plurality of binary codes comprised in an encode table; and
G. searching for an initial letter or each letter's subsequent letters corresponding to the plurality of binary codes disassembled according to the encode table, and replacing the plurality of binary codes with the letters found to generate the word.

To solve the fourth problem, the present invention provides the following technical solutions: a system for decoding an encoded word stock is provided, which comprises:
an encoded word stock configured to store binary encoded words; an input module configured to obtain a binary code of a word from the encoded word stock; an encode table storage module configured to store an encode table, wherein the encode table comprises binary codes corresponding to each letter's subsequent letters and binary codes corresponding to each letter acting as an initial letter; a disassembling module configured to disassemble the binary code of the word into N binary codes comprised in the encode table; and a searching and replacing module configured to search for an initial letter or each letter's subsequent letters corresponding to the binary codes obtained by the disassembling module according to the encode table to generate a letter word.

As compared with the prior art, the present invention sorts occurrence numbers of subsequent letters and performs Huffman encoding on a plurality of column frequencies obtained by summing up frequencies of each column so as to generate an encode table; and binary codes of words obtained according to this encode table increase the coincident code rate of the letters, thereby improving the compression ratio. In addition, obviously, decoding of a binary code in a word stock can be accomplished simply by disassembling the code into a plurality of binary codes according to the encode table and searching for corresponding letters from the encode table for replacement. This decoding process uses simple algorithms and has less operations.

### BRIEF DESCRIPTION OF THE SEVERAL VIEWS OF THE DRAWINGS

Hereinafter, the present invention will be further described with reference to the attached drawings. However, the embodiments shown in the attached drawings are not intended to limit the present invention in any way.
Fig. 1 is a flowchart diagram of a method for compression encoding for a word stock according to an embodiment of the present invention;
Fig. 2 is a detailed flowchart diagram of a step S01 in Fig. 1;
Fig. 3 illustrates a Huffman tree constructed in a step S03 shown in Fig. 1 according to an embodiment;
Fig. 4 is a flowchart diagram of a method for decoding an encoded word stock according to an embodiment of the present invention;
Fig. 5 is a schematic structural view of a system for compression encoding for a word stock according to an embodiment of the present invention; and
Fig. 6 is a schematic structural view of a system for decoding an encoded word stock according to an embodiment of the present invention.

### DETAILED DESCRIPTION OF THE INVENTION

In the present invention, according to a character sequence database (e.g., an English word stock) that is provided beforehand, a frequency of each character in each character sequence acting as an initial character and a frequency of occurrence of each character's subsequent characters are calculated to generate a character frequency table. This frequency table is sorted in a descending order; i.e., a high frequency corresponds to a small serial number and a low frequency corresponds to a large serial number. Huffman encoding is performed on a plurality of column frequencies obtained by summing up frequencies of each column so as to generate an encode table; and binary codes of words obtained according to this encode table increase the coincident code rate of the letters, thereby improving the compression ratio of the word stock.

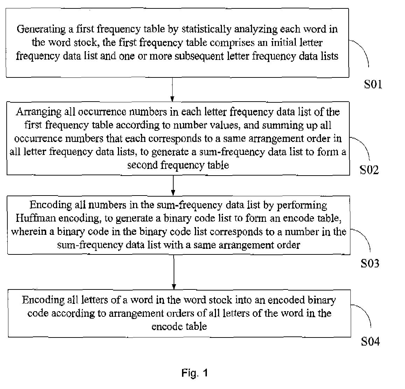

Hereinafter, the present invention will be further described with reference to embodiments thereof. Referring to Fig. 1, a method for compression encoding for a word stock is shown, which comprises the following steps.

Step S01: generating a first frequency table by statistically analyzing each word in the word stock, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock. The meaning of the phrase "subsequent letter" will be explained by taking an English word "make" as an example: the subsequent letter of the letter "m" is "a", the subsequent letter of "a" is "k", the subsequent letter of "k" is "e", and "e" has no subsequent letter; the initial letter "m" of this word is the subsequent letter of "NU", "NU" refers to the beginning of the word, and the subsequent letter of "NU" is an initial letter of each word.

Step S02: arranging all occurrence numbers in each letter frequency data list of the first frequency table according to number values, and summing up all occurrence numbers that each corresponds to a same arrangement order in all letter frequency data lists, to generate a sum-frequency data list to form a second frequency table.

Step S03: encoding all numbers in the sum-frequency data list by performing Huffman encoding, to generate a binary code list to form an encode table, wherein a binary code in the binary code list corresponds to a number in the sum-frequency data list with a same arrangement order.

Step S04: encoding all letters of a word in the word stock into an encoded binary code, according to arrangement orders of all letters of the word in the encode table.

The entire process for compression encoding for the word stock will be detailed herein below

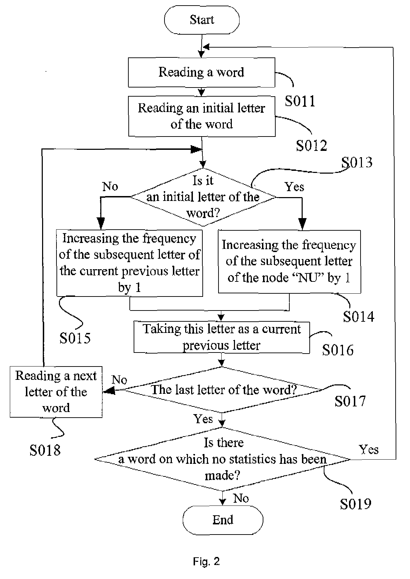

Fig. 2 is a detailed flowchart diagram of the step S01 in Fig. 1. "Statistics are made on individual words in the word stock one by one to calculate occurrence numbers of each letter's subsequent letters" described in the step S01 means that: statistics are made on each letter's subsequent letters in the word stock by making statistics on the words in the word stock one by one and further on letters of each of the words one by one. Specifically, the step S01 comprises the following steps of:
step S011: obtaining a word;
step S012: reading an initial letter of the word;
step S013: determining whether a letter that is currently read is an initial letter;
step S014: if the answer is "yes', increasing the frequency of the letter acting as an initial letter by one and then executing a next step S016;
step S015: if the answer is "no", increasing the frequency of the letter acting as a letter subsequent to a previous letter by one;
step S016: taking the letter that is currently read as a current previous letter;
step S017: determining whether the letter that is currently read is the last letter of the word;
step S018: if the answer is "no", reading a next letter and returning to the step S013; and
step S019: if the answer is "yes", returning to the step S011 and continuing this cycle until statistics have been made on all the words in the word stock.

After the statistics are made, the first frequency table as shown in Table 1 below can be generated, which is a subsequent character frequency table generated through making statistics on the words in the English word stock. Each row of the first frequency table corresponds to occurrence numbers of one letter's subsequent letters. The second row corresponds to occurrence numbers of initial letters taking "NU" as a previous letter, and the first column corresponds to the previous letters.

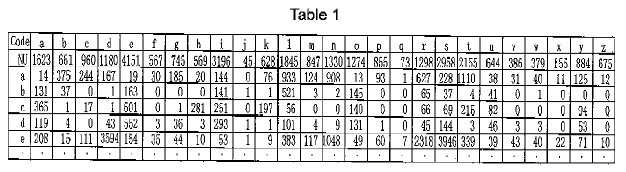

Then, frequencies of each row in Table 1 are sorted in a descending order, and each column in a table obtained after sorting is assigned a serial number. For example, among the subsequent characters of the letter "a" in Table 1, the letter "t" has the highest frequency, the letter "I" has the second highest frequency and the letter "n" has the third highest frequency; therefore, the letter "t" can be arranged at a first position among the subsequent letters of the letter "a" with a serial number being 1, the letter "I" can be arranged at a second position with a serial number being 2 and the letter "n" can be arranged at a third position with a serial number being 3. ln this way, all the letters are arranged according to frequencies thereof in a descending order. Then, frequencies of each column in this table are summed up to obtain a plurality of column frequencies (i.e., the sum frequencies described above). At the end of this table are additionally provided a row for storing the column frequencies of individual columns and a row for storing percent values of the column frequencies of the individual columns. Thus, the second frequency table is generated, as shown in Table 2.

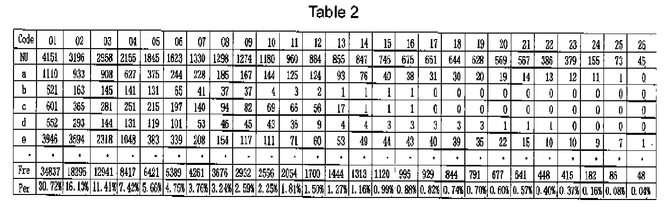

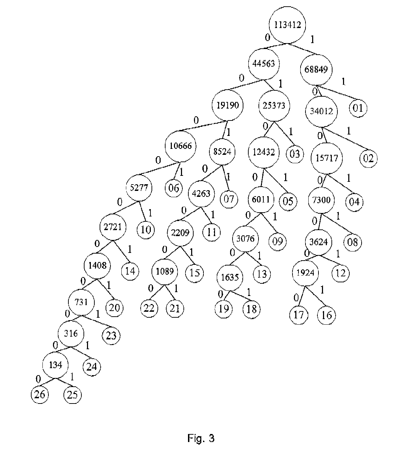

Referring to Fig. 3, the Huffman encoding is performed on the column frequencies obtained above, which comprises the following steps.

Step S031: constructing a Huffman tree by using the column frequencies corresponding to each column in Table 2 as nodes. The Huffman tree, also known as the optimal binary tree, is a binary tree with the shortest weighted path length. The so-called weighted path length of the tree is equal to weights of all leaf nodes in the tree multiplied by path lengths from the leaf nodes to a root node.

Step S032: identifying a left child path of each of the nodes in the Huffman tree as 0 and a right child path of each of the nodes as 1, and then obtaining a path from each of the nodes corresponding to the column frequencies to a root node to obtain binary codes corresponding to the respective column frequencies.

Step S033: assigning the obtained binary codes to columns in which the corresponding column frequencies are located in Table 2, storing the binary codes in the first row, and replacing the frequencies in Table 2 with corresponding subsequent letters to generate an encode table (as shown in Table 3).

**Table 3**

| Huffman | 11 | 101 | 011 | 1001 | 0101 | 0001 | 0011 | 10001 | 01001 | 00001 | 00101 | 100001 | 00001 | 000001 | 001001 | 1000001 | 1000000 | ' |
|---|---|---|---|---|---|---|---|---|---|---|---|---|---|---|---|---|---|---|
| NU | e | i | s | t | l | a | n | r | o | d | c | y | p | m | g | z | b | ' |
| a | t | l | n | r | b | c | s | g | d | i | y | m | p | k | w | u | v | ' |
| b | l | e | o | t | a | r | u | b | s | t | m | n | d | j | k | w | c | ' |
| c | e | a | h | i | t | k | o | y | u | s | r | l | c | b | d | g | f | ' |
| d | e | i | s | o | a | l | y | u | r | d | g | n | b | m | f | h | t | ' |
| e | s | d | r | n | l | t | a | e | m | c | y | p | i | o | g | v | w | ' |
| . | ' | ' | ' | ' | ' | ' | ' | ' | ' | ' | ' | ' | ' | ' | ' | ' | ' | ' |

According to the above encode table (Table 3), letters of words in the word stock are replaced with the binary codes in the encode table to generate binary codes corresponding to the words.

Rules of replacement are as follows. A code of each letter is determined by the letter itself and a previous letter thereof, and the previous letter of an initial letter is "NU". For example, if there is "eda" as a word, a code of the initial letter "e" is determined firstly. Because "e" is an initial letter, the previous letter of "e" is "NU"; and in Table 3, "e" acting as a subsequent letter of "NU" is found to correspond to a code of "11". Next, a code of "d" is searched Specifically, the previous letter of "d" is "e", and correspondingly, "d" acting as a subsequent letter of "e" is found to correspond to a code of "101" in Table 3. Similarly, "a" is found to correspond to a code of "0101". Thus, the binary code corresponding to the word "eda" is "111010101".

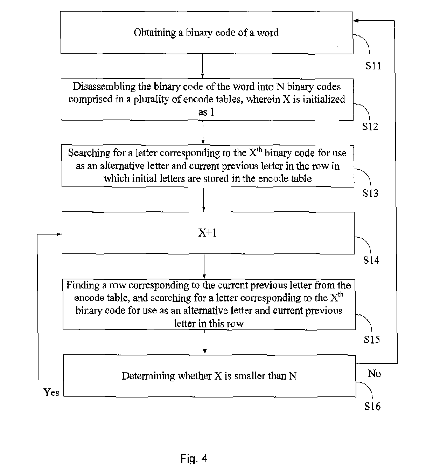

Correspondingly, for the code of the word obtained above, the decoding process is reverse to the encoding process. The decoding process starts with the first code, a previous code of which is certainly "NU", and a next code is a subsequent code of a code previous thereto. Referring to Fig. 4, the decoding process comprises the following steps of:
step S11: obtaining a binary code of a word;
step S12: disassembling the binary code of the word into N binary codes comprised in an encode table, wherein X is initialized to be 1;
step S13: searching for a letter corresponding to the X^{th} binary code for use as a current previous letter in the row in which initial letters are stored in the encode table;
step S14: increasing X by 1;
step S15: finding a row corresponding to the current previous letter from the encode table, and searching for a letter corresponding to the X^{th} binary code for use as a current previous letter in this row; and
step S16: determining whether X is smaller than N; if the answer is "yes", then the process returns to the step S14, and otherwise, the process returns to the step S11.

For example, there is a binary code shown as "0001000110001", a code sequence of "0001", "0001" and "10001" is firstly obtained according to the Huffman tree. The previous code of the first code is "NU"; and in Table 3, the subsequent letter of "NU" corresponding to the code "0001" is found to be "a", which is then used as a current previous letter. It is found from subsequent codes of the current previous letter "a" that the letter corresponding to "0001" is "c". Then, "c" is used as a current previous letter, and further, the letter corresponding to the subsequent code "10001" of "c" is found to be "c". In this way, a corresponding character string of "acc" is obtained through the decoding process.

The compression ratios are compared as follows.

As can be seen from the frequency statistics provided in Table 2, the sum of occupation rates of the four codes from 01 to 04 is 65.68%, with the occupation rate of the code 01 being as high as 30.72%. Table 4 is a statistics table of use frequencies of words in the original word stock. As can be seen from this table, the sum of use frequencies of the first eight letters is only 65.60%. As can be known from this, the coincident code rate obtained when the secondary encoding of the present invention is used is much higher than that obtained when the secondary encoding is not used in the prior art, so the compression ratio of the secondary of the present invention is higher than that obtained when the secondary encoding is not used in the prior art.

**Table 4**

| Word | i e | | n | l | a | t | o | s | r |
|---|---|---|---|---|---|---|---|---|---|
| Frequency 18301 | | 14726 | 9974 | 7803 | 6568 | 6196 | 5903 | 4928 | 4607 |
| Percentage | 16.14% | 12.98% | 8.79% | 6.88% | 5.79% | 5.46% | 5.2% | 4.35% | 4.06% |

Table 5 is a table for comparing the compression ratio of the secondary encoding of the present invention with the compression ratio of the direct Huffman encoding for word stocks in several languages. As can be seen from this table, the compression ratio of the secondary encoding of the present invention is higher than the compression ratio of the direct Huffman encoding by more than 10% and by 16% on average.

**Table 5**

| Language word stock | Compression ratio of Huffman encoding | Compression ratio of the secondary encoding | Compression ratio of the secondary encoding being higher than compression ratio of Huffman encoding by |
|---|---|---|---|
| English | 48.84% | 56.71% | 16.11% |
| Russian | 48.64% | 58.79% | 20.87% |
| Turkish | 51.68% | 59.10% | 14.36% |
| Arabic | 56.50% | 62.59% | 10.78% |
| Portuguese | 46.45% | 56.08% | 20.73% |

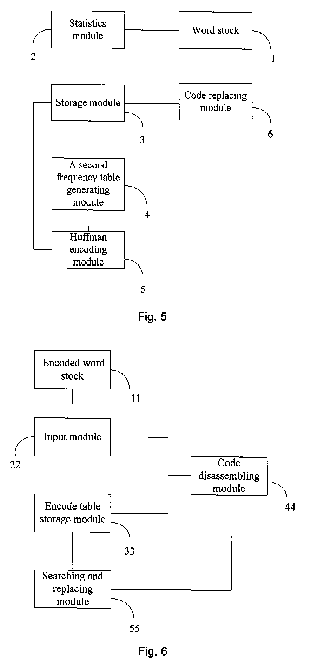

Corresponding to the aforesaid encoding method, the present invention further provides a system for compression encoding for a word stock. Referring to Fig. 5, the system comprises: a word stock 1; a statistics module 2 configured to make statistics on individual words in the word stock one by one to calculate occurrence numbers of each letter's subsequent letters so as to generate a first frequency table, wherein the first frequency table comprises a plurality of rows, each row corresponding to occurrence numbers of one letter's subsequent letters, and also comprises a row corresponding to occurrence numbers of letters acting as initial letters; a storage module 3 configured to store the first frequency table and the encode table generated by a Huffman encoding module 5; a second frequency table generating module 4 configured to sort frequencies of each row in the first frequency table in a descending order, and then sum up frequencies of each column to obtain a plurality of column frequencies so as to generate a second frequency table; the Huffman encoding module 5 configured to perform Huffman encoding on the column frequencies, wherein a column in which each column frequency is located corresponds to a binary code and the frequencies in the second frequency table are replaced with corresponding subsequent letters to generate an encode table; and a code replacing module 6 configured to replace letters of words with the binary codes according to the encode table stored in the storage module to generate binary codes corresponding to the words.

Corresponding to the aforesaid decoding method, the present invention further provides a system for decoding an encoded word stock. Referring to Fig. 6, the system comprises an encoded word stock 11; an input module 22 configured to obtain a binary code of a word from the word stock; an encode table storage module 33 configured to store an encode table; a disassembling module 44 configured to disassemble the binary code of the word into N binary codes comprised in the encode table; and a searching and replacing module 55. The searching and replacing module 55 is configured to: search for a letter corresponding to the first binary code for use as a current previous letter in the row of initial letters in the encode table; subsequently continue to search for a row corresponding to the current previous letter in the encode table; and then search for a letter corresponding to the second binary code as a replacement letter in the row until the last binary code is replaced by a letter, thereby obtaining the word corresponding to the binary code.

In the present invention, intermediate codes are inventively utilized on the basis of the dependence relationships between adjacent letters of words to significantly increase the coincident code rate of words in a word stock; and the frequency difference between the letters is enlarged and full use of the advantages of the Huffman encoding, thereby significantly improving the compression ratio.

What described above are only preferred embodiments of the present invention but are not intended to limit the scope of the present invention. Accordingly, any equivalent structural or process flow modifications that are made on basis of the specification and the attached drawings or any direct or indirect applications in other technical fields shall also fall within the scope of the present invention.

## Claims

1. A method for compression encoding for a word stock, comprising the following steps of:
A. generating a first frequency table by statistically analyzing each word in the word stock, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock;
B. arranging all occurrence numbers in each letter frequency data list of the first frequency table according to number values, and summing up all occurrence numbers that each corresponds to a same arrangement order in all letter frequency data lists, to generate a sum-frequency data list to form a second frequency table;
C. encoding all numbers in the sum-frequency data list by performing Huffman encoding, to generate a binary code list to form an encode table, wherein a binary code in the binary code list corresponds to a number in the sum-frequency data list with a same arrangement order; and
D. encoding all letters of a word in the word stock into an encoded binary code according to arrangement orders of all letters of the word in the encode table.

2. The method for compression encoding for a word stock of Claim 1, wherein the step A further comprises the following steps of:
A1. obtaining a word to read an initial letter thereof;
A2. determining whether a letter that is currently read is an initial letter; if the answer is "yes', then the frequency of the letter acting as an initial letter is increased by one, and if the answer is "no", the frequency of the letter acting as a letter subsequent to a previous letter is increased by one;
A3. taking the letter that is currently read as a current previous letter;
A4. determining whether the letter that is currently read is the last letter of the word; if the answer is "no", then a next letter is read and the process returns to the step A2, and if the answer is "yes", then the process returns to the step A1, and this cycle proceeds until statistics have been made on all the words in the word stock; and
A5. generating the first frequency table from the statistic data, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock.

3. The method for compression encoding for a word stock of Claim 2, wherein the initial letter frequency data list and the one or more subsequent letter frequency data lists in the first frequency table are used as row data in the frequency table, and the same arrangement orders described in the step B are at locations in a same column of the second frequency table.

4. The method for compression encoding for a word stock of Claim 3, wherein the step C further comprises:
C1. constructing a Huffman tree by using the plurality of sum frequencies as a plurality of nodes;
C2. identifying a left child path of each of the nodes in the Huffman tree as 0 and a right child path of each of the nodes as 1, and then obtaining a path from each of the nodes corresponding to the sum frequencies to a root node to obtain binary codes corresponding to the respective sum frequencies; and
C3. assigning the binary codes to columns in which the corresponding sum frequencies are located in the second frequency table, and replacing the frequency data in the second frequency table with corresponding subsequent letters to generate an encode table.

5. The method for compression encoding of a word stock for Claim 4, wherein the step D comprises:
D1. obtaining a word;
D2. finding a column in which the initial letter of the word is located from a row corresponding to the initial letter in the encode table, and replacing the initial letter with a binary code corresponding to the column;
D3. reading a next letter and a previous letter thereof; and
D4. finding a row in which the previous letter is located from the encode table, finding a column in which the letter that is currently read is located from the row, replacing the letter that is currently read with a binary code corresponding to the column, and returning to the step D3 to repeat the process until the last letter of the word has been replaced, thus generating a binary code corresponding to the word, and then returning to the step D1.

6. A method for decoding the compression encoded for a word stock in Claim 1, comprising the following steps of.
E. obtaining a binary code of a word;
F. disassembling the binary code obtained in the step E into a plurality of binary codes comprised in an encode table; and
G. searching for an initial letter or each letter's subsequent letters corresponding to the plurality of binary codes according to the encode table, and replacing the plurality of binary codes with the letters found to generate the word.

7. A system for compression encoding for a word stock, comprising:
a word stock configured to store words;
a statistics module configured to make statistics on the individual words in the word stock to generate a first frequency table, wherein the first frequency table comprises an initial letter frequency data list and one or more subsequent letter frequency data lists, the initial letter frequency data list comprises occurrence numbers of all letters that each is an initial letter of a word in the word stock, and the one or more subsequent letter frequency data lists comprise occurrence numbers of all letters that each is a subsequent letter subsequent to an initial letter to form a word in the word stock;
a storage module configured to store the first frequency table and the encode table generated by a Huffman encoding module;
a second frequency table generating module configured to arrange all occurrence numbers in each letter frequency data list of the first frequency table according to number values, and summing up all occurrence numbers that each corresponds to a same arrangement order in all letter frequency data lists, to generate a sum-frequency data list to form a second frequency table;
a Huffman encoding module configured to encode all numbers in the sum-frequency data list by performing Huffman encoding, to generate a binary code list to form an encode table, wherein a binary code in the binary code list corresponds to a number in the sum-frequency data list with a same arrangement order; and
a code replacing module configured to encode all letters of a word in the word stock into an encoded binary code according to arrangement orders of all letters of the word in the encode table.

8. A system for decoding an encoded word stock, comprising:
an encoded word stock configured to store binary encoded words;
an input module configured to obtain a binary code of a word from the word stock;
an encode table storage module configured to store an encode table, wherein the encode table comprises binary codes corresponding to each letter's subsequent letters and binary codes corresponding to each letter acting as an initial letter;
a disassembling module configured to disassemble the binary code of the word into N binary codes comprised in the encode table; and
a searching and replacing module configured to search for an initial letter or each letter's subsequent letters corresponding to the binary codes according to the encode table to generate a letter word.

9. The system for decoding an encoded word stock of Claim 8, wherein:
the encode table comprises a plurality of rows, each row corresponding to one letter's subsequent letters respectively, and also comprises a row of letters acting as initial letters, and each column of the encode table corresponds to one binary code respectively; and
the searching and replacing module is configured to search for a letter corresponding to the first binary code for use as a current previous letter in the row of initial letters in the encode table; search for a row corresponding to the current previous letter in the encode table; and then search for a subsequent letter corresponding to the second binary code as a replacement letter in the row until the last binary code is replaced by a letter, thus obtaining the word corresponding to the binary code.
